# EUROPÄISCHE PATENTSCHRIFT

(11) **EP 1 929 066 B1**
(45) Veröffentlichungstag und Bekanntmachung des Hinweises auf die Patenterteilung: **05.08.2009**
(21) Anmeldenummer: 06792230.2
(22) Anmeldetag: 22.09.2006
(51) Int. Cl.: C23C 16/54, C23C 16/455

(54) **VORRICHTUNG UND VERFAHREN ZUR KONTINUIERLICHEN GASPHASENABSCHEIDUNG UNTER ATMOSPHÄRENDRUCK UND DEREN VERWENDUNG**
DEVICE AND METHOD FOR CONTINUOUS CHEMICAL VAPOUR DEPOSITION UNDER ATMOSPHERIC PRESSURE AND USE THEREOF
DISPOSITIF ET PROCEDE DE SEPARATION CONTINUE EN PHASE GAZEUSE SOUS PRESSION ATMOSPHERIQUE ET LEURS UTILISATIONS ASSOCIEES

(30) Priorität: 23.09.2005 DE 102005045582
(43) Veröffentlichungstag der Anmeldung: 11.06.2008
(73) Patentinhaber: Fraunhofer-Gesellschaft zur Förderung der angewandten Forschung e.V., 80686 München (DE)
(72) Erfinder: REBER, Stefan, 79194 Gundelfingen (DE); HURRLE, Albert, 79183 Waldkirch (DE); SCHILLINGER, Norbert, 79241 Ihringen (DE)
(74) Vertreter: Pfenning, Meinig & Partner GbR
(86) Internationale Anmeldenummer: PCT/EP2006/009228
(87) Internationale Veröffentlichungsnummer: WO 2007/033832

(56) Entgegenhaltungen:
- EP-A- 1 394 283
- EP-A1- 0 545 542
- GB-A- 1 328 390
- US-A1- 3 367 304
- US-A1- 3 790 404
- US-A1- 2004 065 255
- REBER S ET AL: "Crystalline silicon thin-film solar cells-recent results at Fraunhofer ISE" SOLAR ENERGY, PERGAMON PRESS. OXFORD, GB, Bd. 77, Nr. 6, Dezember 2004 (2004-12), Seiten 865-875, XP004661827 ISSN: 0038-092X

## Beschreibung

Die Erfindung betrifft eine Vorrichtung und ein Verfahren zur kontinuierlichen Gasphasenabscheidung unter Atmosphärendruck auf Substraten. Die Vorrichtung basiert hierbei auf einer Reaktionskammer, an deren offenen Seiten die Substrate entlanggeführt werden, wodurch auf der dem Kammerinneren zugewandten Seite der Substrate die entsprechenden Beschichtungen erfolgen können.

Die Herstellung von dünnen Schichten aus gasförmigen Ausgangsmaterialien (sog. Precursor) wird mit einer Vielzahl von technischen Realisierungen durchgeführt. Gemeinsam ist allen Verfahren, dass ein gasförmiger oder in die Gasphase gebrachter Precursor in einen Reaktionsraum geleitet wird, dort durch die Einkopplung von Energie zersetzt wird und sich Bestandteile des Gases an zu beschichteten Teilen ablagern. Eines dieser Verfahren ist die Atmosphärendruck-Gasphasenabscheidung (genannt APCVD nach dem englischen atmospheric pressure chemical vapor deposition). Sie ist **dadurch gekennzeichnet, dass** sich der Precursor und der Prozessraum nahezu auf Atmosphärendruck befinden. Ein Beispiel für APCVD ist die APCVD-Epitaxie von Siliciumschichten aus Chlorsilanen. Bei ihr wird das Chlorsilan üblicherweise mit Wasserstoff vermischt im Reaktionsraum bei Temperaturen um 1000 - 1200 °C zersetzt, und Silicium scheidet sich mit der gleichen Kristallorientierung auf einem kristallinem Siliciumsubstrat ab. Dieser Prozess wird u.a. für Solarzellen eingesetzt, die aus dünnen, kristallinen Si-Schichten bestehen. Insbesondere für diesen Anwendungsfall sind Silicium-Abscheidereaktoren vonnöten, die eine etwa 10-20 µm dicke Si-Schicht sehr kostengünstig (unter 30€/m²) und mit hohem Durchsatz (> 20 m²/h) abscheiden können. Die dem Stand der Technik entsprechenden Reaktoren können diese Anforderungen nicht erreichen, weil sie a) zuwenig Durchsatz haben (z.B. ASM Epsilon 3000: 1 m²/h) und b) das im Precursor enthaltene Silicium nur sehr unvollständig ausnutzen (wenige Prozent). Eine neue Entwicklung betrifft die Realisierung eines Hochdurchsatz-Reaktors für die Gasphasenabscheidung / -epitaxie von Silicium (Hurrle, S. Reber, N. Schillinger, J. Haase, J.G. Reichart, "High Throughput Continuous CVD Reactor for Silicon Deposition", In Proc. 19th European Conference on Photovoltaic Energy Conversion, (WIP - Munich, ETA-Florence 2004, S. 459). Neben der Abscheidung von Silicium sind prinzipiell dabei auch alle anderen im Atmosphärendruck abscheidbaren Schichten in diesem Reaktor darstellbar.

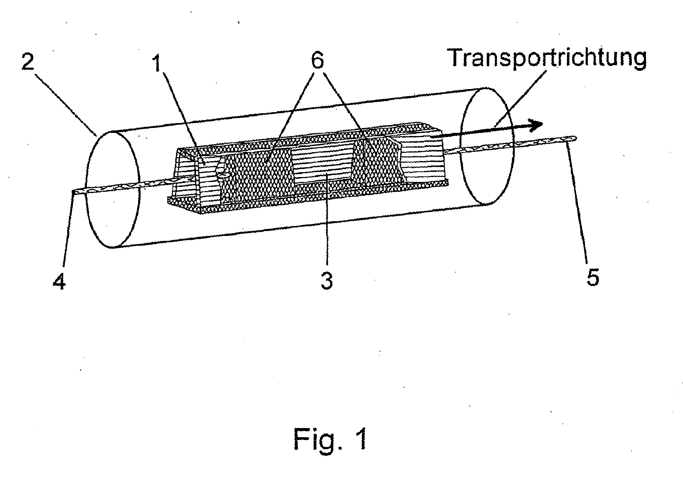

Der Reaktor realisiert folgendes Prinzip (s. Fig. 1): Durch eine Gasschleuse werden 2 parallele Reihen von Substraten 1, 1' in ein Rohr 2 eingefahren. Im Inneren des Rohrs befindet sich eine links und rechts offene Kammer 3. Diese Öffnungen der Kammer werden im Folgenden auch "Abscheidezone" genannt. Je eine Substratreihe wird an einer offenen Seite der Kammer vorbeibewegt, verschließt die Öffnung und dichtet dabei das Kammervolumen gegen das Rohrvolumen ab. In die Kammer wird der Precursor von vorne (d.h. der Seite der Eingangs-Gasschleuse) durch einen Gaseinlass 4 eingelassen und im hinteren Bereich der Kammer durch einen Gasauslass 5 abgesaugt. Ein besonderes Merkmal der Abscheidekammer ist, dass gegenüber dem außerhalb der Kammer liegenden Volumen ein kleiner Unterdruck gehalten wird. Dieser verhindert, dass große Mengen an Prozessgas aus der Kammer austreten. Bei den o.g. Temperaturen zersetzt sich der Precursor (hier: SiHCl₃/H₂) und Silicium scheidet sich vornehmlich auf den sich kontinuierlich nach hinten bewegenden Innenseiten der Substratreihen ab. Die Prozessgasmischung wird bevorzugt so gewählt, dass am hinteren Ende der Kammer das Gas vollständig verarmt ist und keine weitere Abscheidung auftritt. Dadurch entsteht naturgemäß ein Abscheideprofil (d.h. ein Profil unterschiedlicher Abscheidedicke), was aber durch die Bewegung der Substrate vollständig ausgeglichen wird. Die Substrate verlassen die Anlage am hinteren Ende des Rohres wieder durch eine Gasschleuse. Eine weitere Besonderheit des Reaktors ist, dass die Substrate kontinuierlich mit gleichmäßiger Vorschubgeschwindigkeit beschichtet werden können, d.h. es ist kein getakteter, steuerungsmäßig aufwendiger Betrieb notwendig.

An den aus Graphit hergestellten Teilen 6 der Kammer sowie anderen Flächen entstehen unerwünschte, "parasitäre" Abscheidungen. Diese müssen regelmäßig entfernt werden, damit sämtliche Querschnitte erhalten bleiben und damit sich keine störenden Flitter bilden. Von parasitären Abscheidungen sind neben Kammerflächen z.B. auch die Gaseinlassdüse bzw. die Gasauslassöffnung betroffen.

Eine für die Produktion von Solarzellen geeignete Anlage muss das beschriebene Prinzip im Durchsatz skalieren, sowie die Betriebszeit der Anlage möglichst optimieren, d.h. möglichst einen unterbrechungsfreien Dauerbetrieb gewährleisten. Dieser Anforderung nimmt sich die vorliegende Erfindung an.

Ausgehend hiervon war es Aufgabe der vorliegenden Erfindung, eine Abscheideanlage für die chemische Gasphasenabscheidung bereitzustellen, mit der der Durchsatz gegenüber dem aus dem Stand der Technik bekannten Verfahren deutlich erhöht werden kann.

Diese Aufgabe wird durch die gattungsgemäße Vorrichtung mit den kennzeichnenden Merkmalen des Anspruchs 1, den Gasphasenabscheidungsreaktor mit den Merkmalen des Anspruchs 12 und das Verfahren mit den Merkmalen des Anspruchs 14 gelöst. Die weiteren abhängigen Ansprüche zeigen vorteilhafte Weiterbildungen auf.

Erfindungsgemäß wird eine Vorrichtung zur kontinuierlichen Gasphasenabscheidung unter Atmosphärendruck auf Substraten bereitgestellt, die eine an zwei sich gegenüberliegenden Seiten offene Reaktionskammer aufweist. An den offenen Seiten entlang können die zu beschichtenden Substrate transportiert werden, wodurch die Reaktionskammer verschlossen wird. Die Reaktionskammer ist dabei so aufgebaut, dass sie jeweils eine zur Transportrichtung der Substrate stirn-und rückseitige Wand oder ein anderes Verschlussmittel aufweist, die sich über zwei sich gegenüberliegende Seitenwände verbunden sind. Wesentlich für die vorliegende Erfindung ist es nun, dass die Seitenwände der erfindungsgemäßen Vorrichtung mindestens jeweils zwei Ein- und Auslässe für Prozessgase aufweisen, die zumindest bereichsweise in Transportrichtung der Substrate alternierend angeordnet sind. Durch die alternierende Anordnung der Gasein- und -auslässe passieren die Gasströme die Vorrichtung im Gegenstromprinzip. Hierdurch kann die Bildung parasitärer Beschichtungen in der Vorrichtung, d.h. an Stellen, die nicht beschichtetet werden sollen, minimiert oder ganz verhindert werden. Eine Unterbrechung des kontinuierlichen Betriebs ist hierfür im Gegensatz zum Stand der Technik nicht erforderlich, wodurch ein deutlich höherer Durchsatz erreichbar ist.

Das erfindungsgemäße Konzept basiert hierbei auf den folgenden Ansätzen:
- Die Anzahl parallel durch die Vorrichtung transportierter Substratreihen kann erhöht werden.
- Die Länge der Abscheidezone wird vergrößert.
- Im laufenden Abscheidebetrieb kann die Bildung parasitärer Beschichtungen verhindert werden oder parasitär beschichtete Flächen können in kontinuierlichem Betrieb gereinigt werden.

Diese Ansätze können durch folgende Maßnahmen gelöst werden:
- Durch geschickte Anordnung der Gaseinlässe und Gasauslässe sowie der zugehörigen Gasströmung.
- Durch geschickte Verschiebung des in der Gasmischung vorhandenen Reaktionsgleichgewichtes.
- Vorzugsweise sind die Gaseinlässe und Gasauslässe in Form von Düsen an den Seitenwänden angeordnet.

Bei dieser Variante ist der Gaseinlass auf einer ersten Seitenwand angeordnet, während der Gasauslass auf der gegenüberliegenden Seitewand angeordnet ist. Dadurch kommt es zur Ausbildung eines im wesentlichen senkrecht zur Transportrichtung verlaufenden Gasstrom. Werden diese nun alternierend angeordnet, kommt es zur Anwendung des Gegenstrom-Prinzips, da die Gasströme der aufeinanderfolgenden Gaseinlässe bzw. Gasauslässe in entgegengesetzter Richtung verlaufen.

Vorzugsweise weist die Vorrichtung mindestens einen Gaseinlass für die Einleitung eines Precursors zur Abscheidung auf den Substraten auf. In einer weiteren bevorzugten Ausführungsform der erfindungsgemäßen Vorrichtung weist diese ebenso mindestens einen Gaseinlass für die Einleitung eines Ätzgases zur Beseitigung parasitärer Abscheidungen auf.

Eine zweite Variante der erfindungsgemäßen Vorrichtung beruht darauf, dass die Gaseinlässe und die Gasauslässe in Form von sich senkrecht zur Transportrichtung erstreckenden Rohren mit mehreren sich über die Rohrlänge ausbreitenden Düsen ausgebildet sind. Somit verwendet man hier ein System mit mindestens einem Gaseinlassrohr und einem Gasauslassrohr. Die einzelnen Rohre sind dabei vorzugsweise in Form von Blöcken angeordnet. Eine bevorzugte Variante sieht dabei vor, dass ein Block aus zwei Gaseinlassrohren mit dazwischenliegenden Gasauslassrohren besteht. Die Vorrichtung kann dabei insgesamt eine Vielzahl derartiger in Transportrichtung sequentiell angeordneter Blöcke aufweisen. Ebenso ist es möglich, dass in dem Block auch ein zusätzliches Gaseinlassrohr für ein Ätzgas angeordnet ist.

Als zu beschichtende Substrate werden vorzugsweise Silicium, Keramik, Glas und/oder deren Verbunde oder Schichtsysteme eingesetzt.

Erfindungsgemäß wird auch ein Gasphasenabscheidungsreaktor bereitgestellt, der einen Heizofen enthält, in dem mindestens zwei parallel zueinander angeordnete Vorrichtungen nach einem der vorhergehenden Ansprüche angeordnet sind. Ein weiterer Gasphasenabscheidüngsreaktor enthält ebenfalls ein Heizofen, in dem allerdings die erfindungsgemäßen Vorrichtungen sequentiell angeordnet sind.

Erfindungsgemäß wird ebenso ein Verfahren zur kontinuierlichen Gasphasenabscheidung unter Atmosphärendruck auf Substraten bereitgestellt, bei dem die erfindungsgemäße Vorrichtung zum Einsatz kommt. Dabei wird die Gaszuführung so gesteuert, dass gleichzeitig während der Abscheidung auf den Substraten parasitäre Abscheidungen in der Vorrichtung verhindert und/oder entfernt werden.

Vorzugsweise wird über mindestens einen Gaseinlass mindestens ein Precursor zugeführt, der dann während des Beschichtungsvorganges auf den Substraten abgeschieden wird. Über mindestens einen Gasauslass wird Gas dabei aus der Vorrichtung abgesaugt. Die Absaugung kann dabei vorzugsweise über eine Pumpe erfolgen.

Eine bevorzugte Variante des erfindungsgemäßen Verfahrens sieht nun vor, dass durch periodische Änderung der Zusammensetzung des mindestens einen zugeführten Gases parasitäre Abscheidungen in der Vorrichtung während des Abscheidevorgangs verhindert und/oder entfernt werden können. Sollen parasitäre Abscheidungen entfernt werden, so wird vorzugsweise mindestens ein Ätzgas zugeführt, um diese zu entfernen. Dies erfolgt dann über ein Gaseinlass für mindestens ein Ätzgas. Hierbei ist es sowohl möglich, dass das Ätzgas über einen separaten Gaseinlass zugeführt wird, als auch, das das Ätzgas und der Precursor über die gleichen Gaseinlässe zugeführt werden, was dann zeitlich getaktet erfolgt.

Besonders bevorzugt ist es beim erfindungsgemäßen Verfahren, den mindestens einen Precursor und das mindestens eine Ätzgas sich periodisch abwechselnd über unterschiedliche Gaseinlässe der Vorrichtung zuzuführen. Weiterhin ist es bevorzugt, dass das mindestens eine Ätzgas und der mindestens eine Precursor zueinander chemisch kompatibel sind.

Vorzugsweise sollten die Gaseinlässe in den Seitenwänden bzw. die Düsen in den Gaseinlass so positioniert sein, dass sie auf die Substrate gerichtet sind, so dass eine Gasströmung in Richtung der Substrate erzeugt werden kann. Hingegen sollten die Gaseinlässe bzw. die Düsen der Gaseinlassrohre für das mindestens eine Ätzgas auf die Flächen der Vorrichtung mit parasitären Abscheidungen gerichtet sein, so dass die parasitären Abscheidungen auf diesen Bauteilen der Vorrichtung zurückgeätzt werden können.

Weiterhin ist es bevorzugt, dass bei dem zuvor beschriebenen blockweisen Aufbau innerhalb der Vorrichtung unterschiedliche Prozessgase zugeführt werden, so dass unterschiedliche Schichten oder Schichtzusammensetzungen während des Transports der Substrate auf diesen abgeschieden werden können.

Das erfindungsgemäße Verfahren kann nach zwei verschiedenen Varianten durchgeführt werden. In einer ersten Variante sind Schlitze zwischen den Begrenzungen der Prozesskammer und den Substraten vorhanden, deren Dimension sich zu keinem Zeitpunkt wesentlich ändert. Dadurch wird sowohl ein kontinuierlicher Transport der Substrate durch die Vorrichtung ermöglicht (d.h. es kommt zu keinem Zeitpunkt zu einem Stillstand des Substrats), als auch ein getakteter Transport bestehend aus einem Transporttakt und einem Ruhetakt. Ein Austritt von Prozessgasen wird durch eine geeignete Spülgasführung verhindert. Alternativ können auch Gleitdichtungen verwendet werden, um eine Abdichtung zwischen Substrat und Prozesskammer zu erreichen. Allerdings kann bei hohen Temperatur und hohen Reinheitsanforderungen bezüglich einer derartigen Abdichtung Probleme auftreten.

Eine zweite bevorzugte Variante sieht vor, dass sich die Breite der Schlitze während des Prozesses periodisch ändert und die Substrate getaktet durch die Vorrichtung transportiert werden. Während eines Abscheidetakts ruhen die Substrate auf den Begrenzungen der Prozesskammer und schließen selbige ausreichend gasdicht ab. Während eines kurzen Transportakts heben die Substrate von der Kammer ab, werden weitertransportiert und wieder abgesetzt. Der Gasaustritt aus den während des Transportakts entstehenden Schlitzen wird durch geeignete Spülgasführung verhindert. Dies erfolgt wie bei der zuvor beschriebenen Variante dadurch, dass der Druck in der Kammer gegenüber dem umgebenden Druck soweit abgesenkt wird, dass ein ausreichender Spülgasfluss ermöglicht wird oder zumindest ein Fluss nach außen verhindert wird. Die Vorteile dieser zweiten Variante bestehen zum einen in einer höheren Toleranz gegenüber Druck- oder Flussschwankungen und zum anderen in einem kontaminations-ärmeren Abscheidevolumen, z.B. bezüglich des Spülgases und der damit mitgeschleppten Verunreinigung.

Anhand der nachfolgenden Beispiele soll der erfindungsgemäße Gegenstand näher erläutert werden, ohne diesen auf die hier dargestellten speziellen Ausführungsformen einschränken zu wollen.

Fig. 1 zeigt einen aus dem Stand der Technik bekannten Gasphaseabscheidereaktor.

Fig. 2 zeigt eine bevorzugte Ausführungsform der erfindungsgemäßen Vorrichtung mit in Transportrichtung alternierenden Gaseinlässen und Gasauslässen.

Fig. 3 zeigt eine Ausführungsform der erfindungsgemäßen Vorrichtung, bei der blockweise angeordnete Gaseinlassrohre und Gasauslassrohre verwendet werden.

Fig. 4 zeigt die in Fig. 3 dargestellte Ausführungsvariante in der Draufsicht.

Fig. 5 zeigt eine weitere Ausführungsform der erfindungsgemäßen Vorrichtung mit blockweiser Anordnung von Gaseinlassrohren und Gasauslassrohren sowie zusätzlichen Rückätzrohren.

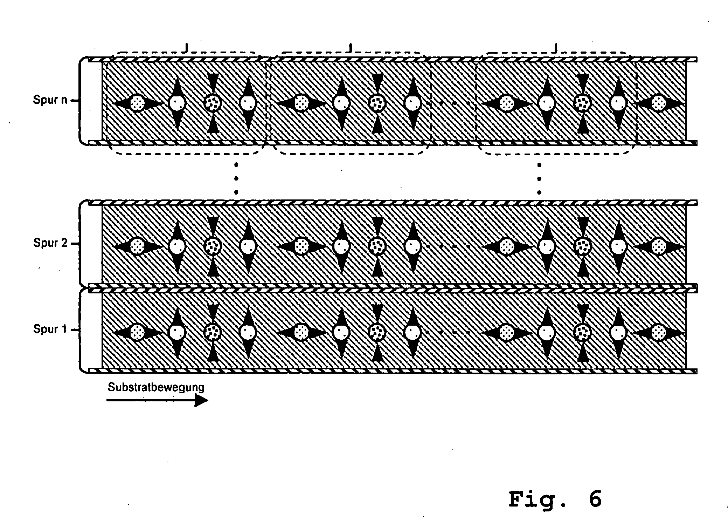

Fig. 6 zeigt eine erfindungsgemäße Anordnung, in der mehrere erfindungsgemäße Vorrichtungen gemäß Fig. 5 parallel zueinander angeordnet sind.

### Beispiel 1

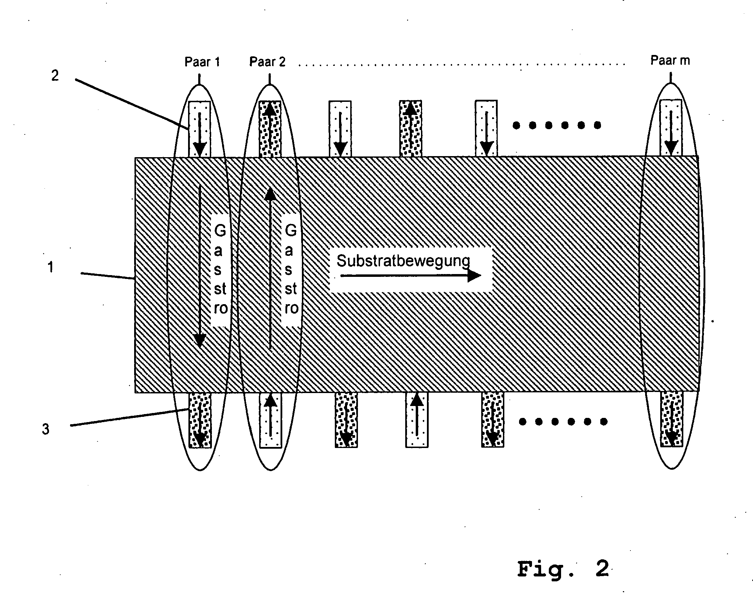

In einer ersten bevorzugten Ausführungsform wird der Precursor durch Einlassdüsen in die Abscheidekammer 1 befördert, die sich an den Längsseiten der Abscheidekammer befinden, die nicht durch die Substrate gebildet wird (s. Fig. 2). Je ein Gaseinlass 2 und Gasauslass 3 stehen sich ungefähr gegenüber, zwei aufeinanderfolgende Paare (z.B. Paar 1 und Paar 2 aus Fig. 2) sind gespiegelt angeordnet. Die Gasströme der aufeinanderfolgenden Paare laufen dann im Gegenstrom. Erfindungsgemäß wird das System so betrieben, dass vom Gaseinlass bis zum Gasauslass eines Paares der Precursor zu einem hohen Prozentsatz des theoretisch möglichen Wertes ausgenutzt wird, d.h. dass ein Profil entsteht, bei dem an irgendeinem Punkt aufgrund Gasabreicherung nahezu keine Abscheidung mehr geschieht. Das Rückätzen parasitärer Schichten geschieht durch die Verwendung von chemisch kompatiblem Ätzgas in einem oder mehreren Einlass-Paaren, während die übrigen Paare sich im Abscheidebetrieb befinden.
Alternativ kann das Rückätzen durch Ändern der Gaszusammensetzung des Precursors realisiert werden (z.B. Anheben des CI/H-Verhältnisses bei Chlorsilanen). Die Gasströmung wird beim Rückätzen so geändert, dass bevorzugt die parasitär beschichteten Flächen angegriffen werden, und die später zu nutzende Schicht weitestgehend geschont wird. Dabei muss mindestens die eine Düsenpaar zugeordnete, parasitär beschichtete Fläche effektiv rückgeätzt werden. Nach erfolgtem Rückätzen wird das Düsenpaar wieder mit Precursor für Abscheidung beaufschlagt, und das Rückätzen beginnt erneut an einem anderen Düsenpaar. Dieser Prozess wird periodisch weitergeführt.

Falls es für den Prozess Vorteile bringt, kann periodisch die Rolle der Gaseinlässe und -auslässe vertauscht werden.

Je m Paare bilden eine Abscheidkammer.

### Beispiel 2

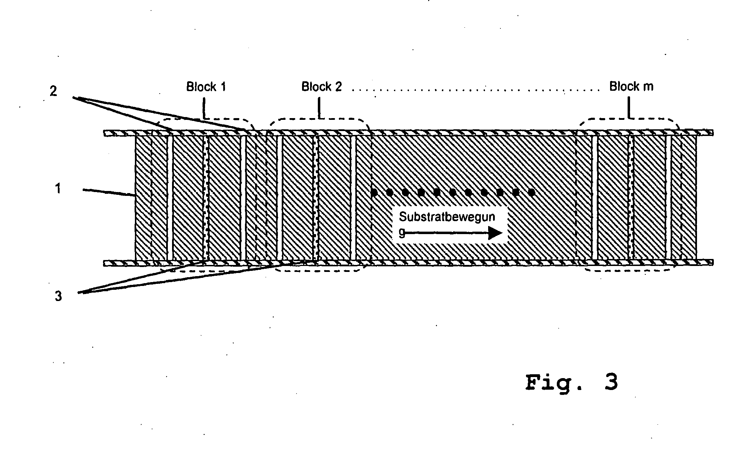

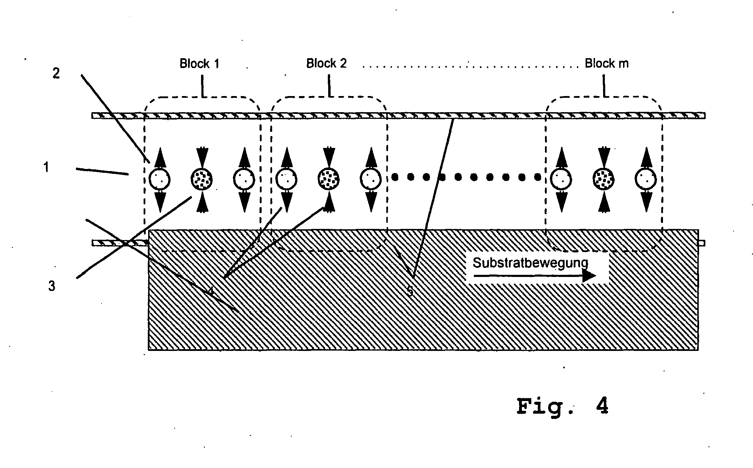

Eine zweite Ausprägung der Erfindung ist folgendermaßen charakterisiert: statt einer Einlass-/ bzw. Auslassdüse seitlich der Abscheidekammer durchqueren Gaseinlassrohre mit mehreren auf der Rohrlänge verteilten Einlass-/Auslassdüsen die Abscheidekammer senkrecht zur Bewegungsrichtung. Einem Gasauslassrohr sind je ein Gaseinlassrohr davor und dahinter zugeordnet (s. Fig. 3 und 4). Das Gas wird bevorzugt in Richtung Substrate aus den Gaseinlassrohren ausgeblasen. Im folgenden wird diese Anordnung "Block" genannt. Im Abscheidebetrieb wird Precursor in die beiden Gaseinlassrohre eingelassen, das verbrauchte Gas wird vom Gasauslassrohr dazwischen abgesaugt. In der Abscheidekammer sind beliebig viele dieser Blöcke hintereinander angeordnet. Zum Rückätzen werden ein oder mehrere Blöcke mit Ätzgas betrieben, das in seinem Fluss so gewählt wird, dass die parasitär beschichteten Flächen bevorzugt begast und damit rückgeätzt werden. Die Ausprägung 2 findet folgende Erweiterung: statt je 2 Gaseinlassrohren pro Rückätzrohr werden wird der Block durch zusätzliche Gaseinlassrohre vor bzw. nach dem Gasauslassrohr ergänzt ("erweiterter Block"). Je m Stück (erweiterter) Blöcke bilden eine Abscheidekammer.

### Beispiel 3

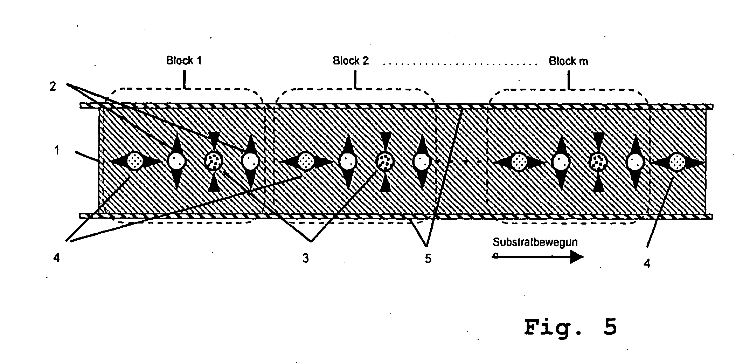

In einer dritten Ausprägung wird der Block der Ausprägung 2 durch ein vorangestelltes, separates Rückätzrohr ergänzt (s. Fig. 5). Dieses Rückätzrohr kann mit Ätzgas beaufschlagt werden, und die jeweils benachbarten Gasein- und auslassrohre rückätzen. Die Richtung des Ätzgasstroms wird so gewählt, dass die Orte parasitärer Abscheidungen bevorzugt geätzt werden. Das Rückätzen kann sowohl getaktet wie in Ausprägung 1 und 2 geschehen (d.h. die Zufuhr an Precursor an den benachbarten Gaseinlassrohren wird während des Rückätzens unterbrochen), als auch im laufenden Abscheidebetrieb aller Gaseinlassrohre. Ein wesentliches Merkmal dieses Betriebs ist, dass durch das Ätzgas die Gaszusammensetzung am Ort der Gaseinlass- und Gasauslassrohre so geändert wird, dass das Reaktionsgleichgewicht von Abscheidung in Richtung Ätzen verschoben wird. Durch die Richtungsgebung und Menge des Ätzgases wird weitestgehend verhindert, dass am Substrat selbst geätzt wird. Auch die Blöcke der Ausprägung 3 können wie in Ausprägung 2 durch zusätzliche Gaseinlassrohre erweitert werden. Je m der Blöcke sind zu einer Abscheidekammer seriell hintereinander angeordnet, ein Rückätzrohr nach dem m-ten Block schließt eine Abscheidekammer ab.

## Patentansprüche

1. Vorrichtung zur kontinuierlichen Gasphasenabscheidung unter Atmosphärendruck auf Substraten enthaltend eine an zwei sich gegenüberliegenden Seiten offene Reaktionskammer, an deren offenen Seiten entlang unter Verschluss der Reaktions-kammer die Substrate transportierbar sind, wobei die Reaktionskammer jeweils eine zur Transportrichtung der Substrate stirn- und rückseitige Wand aufweist, die über zwei sich gegenüberliegende Seitenwände verbunden sind,
**dadurch gekennzeichnet,**
**dass** die Seitenwände mindestens jeweils zwei Ein- und Auslässe für Prozessgase aufweisen, die zumindest bereichsweise in Transportrichtung alternierend angeordnet sind.

2. Vorrichtung nach Anspruch 1,
**dadurch gekennzeichnet, dass** die Gaseinlässe und Gasauslässe in Form von Düsen an den Seitenwänden angeordnet sind.

3. Vorrichtung nach einem der vorhergehenden Ansprüche,
**dadurch gekennzeichnet, dass** ein Gaseinlass auf einer Seitenwand einem Gasauslass auf der gegenüberliegenden Seitenwand unter Ausbildung eines im wesentlichen senkrecht zur Transportrichtung verlaufenden Gasstroms zugeordnet ist.

4. Vorrichtung nach einem der vorhergehenden Ansprüche,
**dadurch gekennzeichnet, dass** die Vorrichtung mindestens einen Gaseinlass für die Einleitung eines Precursors zur Abscheidung auf den Substraten aufweist.

5. Vorrichtung nach einem der vorhergehenden Ansprüche,
**dadurch gekennzeichnet, dass** die Vorrichtung mindestens einen Gaseinlass für die Einleitung von Ätzgas zur Beseitigung parasitärer Abscheidungen aufweist.

6. Vorrichtung nach Anspruch 1,
**dadurch gekennzeichnet, dass** die Gaseinlässe und Gasauslässe in Form von sich senkrecht zur Transportrichtung ersteckenden Rohren mit mehreren sich über die Rohrlänge ausbreitenden Düsen ausgebildet sind.

7. Vorrichtung nach Anspruch 6,
**dadurch gekennzeichnet, dass** mehrere Rohre in Form von Blöcken angeordnet sind.

8. Vorrichtung nach Anspruch 7,
**dadurch gekennzeichnet, dass** ein Block aus zwei Gaseinlassrohren mit dazwischen liegendem Gasauslassrohr besteht.

9. Vorrichtung nach einem der Ansprüche 7 oder 8,
**dadurch gekennzeichnet, dass** die Vorrichtung eine Vielzahl von in Transportrichtung sequentiell angeordneten Blöcken aufweist.

10. Vorrichtung nach einem der Ansprüche 7 bis 9,
**dadurch gekennzeichnet, dass** der Block ein zusätzliches Gaseinlassrohr für ein Ätzgas aufweist.

11. Vorrichtung nach einem der vorhergehenden Ansprüche,
**dadurch gekennzeichnet, dass** die Substrate aus Silicium, Keramik, Glas und/oder deren Verbunden oder Schichtsystemen bestehen.

12. Gasphasenabscheidungsreaktor enthaltend einen Heizofen, in dem mindestens zwei parallel zueinander angeordneten Vorrichtungen nach einem der vorhergehenden Ansprüche angeordnet sind.

13. Gasphasenabscheidungsreaktor enthaltend einen Heizofen, in dem mindestens zwei sequentiell angeordnete Vorrichtungen nach einem der Ansprüche 1 bis 11 angeordnet sind.

14. Verfahren zur kontinuierlichen Gasphasenabscheidung unter Atmosphärendruck auf Substraten unter Verwendung einer Vorrichtung nach einem der Ansprüche 1 bis 11, bei dem die Gaszuführung so gesteuert wird, dass gleichzeitig während der Abscheidung auf den Substraten parasitäre Abscheidungen in der Vorrichtung verhindert und/oder entfernt werden.

15. Verfahren nach Anspruch 14,
**dadurch gekennzeichnet, dass** über mindestens einen Gaseinlass mindestens ein Precursor zugeführt wird.

16. Verfahren nach Anspruch 14 oder 15,
**dadurch gekennzeichnet, dass** über mindestens einen Gasauslass Gas aus der Vorrichtung abgesaugt wird.

17. Verfahren nach Anspruch 16,
**dadurch gekennzeichnet, dass** die Absaugung über eine Pumpe erfolgt.

18. Verfahren nach einem der Ansprüche 14 bis 17,
**dadurch gekennzeichnet, dass** durch periodische Änderung der Zusammensetzung des mindestens einen zugeführten Gases parasitäre Abscheidungen in der Vorrichtung verhindert und/oder entfernt werden.

19. Verfahren nach einem der Ansprüche 14 bis 18,
**dadurch gekennzeichnet, dass** durch Zuführung mindestens eines Ätzgases parasitäre Abscheidungen in der Vorrichtung entfernt werden.

20. Verfahren nach einem der Ansprüche 14 bis 19,
**dadurch gekennzeichnet, dass** über mindestens einen Gaseinlass mindestens ein Ätzgas zur Entfernung parasitärer Abscheidungen zugeführt wird.

21. Verfahren nach Anspruch 20,
**dadurch gekennzeichnet, dass** das mindestens eine Ätzgas über mindestens einen Gaseinlass separat zugeführt wird.

22. Verfahren nach einem der Ansprüche 19 bis 21,
**dadurch gekennzeichnet, dass** der mindestens eine Precursor und das mindestens eine Ätzgas über die gleichen Gaseinlässe zugeführt werden.

23. Verfahren nach einem der Ansprüche 19 bis 22,
**dadurch gekennzeichnet, dass** der mindestens eine Precursor und das mindestens eine Ätzgas sich periodisch abwechselnd über unterschiedliche Gaseinlässe der Vorrichtung zugeführt werden.

24. Verfahren nach einem der Ansprüche 19 bis 23,
**dadurch gekennzeichnet, dass** der mindestens eine Precursor und das mindestens eine Ätzgas zueinander chemisch kompatibel sind.

25. Verfahren nach einem der Ansprüche 14 bis 24,
**dadurch gekennzeichnet, dass** ein erster Gasstrom von einem Gaseinlass in der ersten Seitenwand zu einem Gasauslass in der zweiten Seitenwand und parallel dazu ein zweiter Gasstrom von einem Gaseinlass in der zweiten Seitenwand zu einem Gasauslass in der ersten Seitenwand im Gegenstromprinzip geführt wird.

26. Verfahren nach einem der Ansprüche 14 bis 25,
**dadurch gekennzeichnet, dass** die Düsen der Gaseinlassrohre für den mindestens einen Precursor auf die Substrate gerichtet sind, so dass eine Gasströmung in Richtung der Substrate erzeugt wird.

27. Verfahren nach einem der Ansprüche 14 bis 26,
**dadurch gekennzeichnet, dass** die Düsen der Gaseinlassrohre für das mindestens eine Ätzgas auf die Flächen der Vorrichtung mit parasitären Abscheidungen gerichtet sind, so dass die parasitären Abscheidungen zurückgeätzt werden.

28. Verfahren nach einem der Ansprüche 14 bis 27,
**dadurch gekennzeichnet, dass** in jedem Block unterschiedliche Prozessgase zugeführt werden, so dass unterschiedliche Schichten oder Schichtzusammensetzungen abgeschieden werden.

29. Verfahren nach einem der Ansprüche 14 bis 28,
**dadurch gekennzeichnet, dass** Schlitze zwischen den Begrenzungen der Prozesskammer und den Substraten vorhanden sind, wobei sich die Dimensionen der Schlitze zwischen den Begrenzungen der Prozesskammer und den Substraten zeitlich nicht wesentlich ändern.

30. Verfahren nach einem der Ansprüche 14 bis 28,
**dadurch gekennzeichnet, dass** Schlitze zwischen den Begrenzungen der Prozesskammer und den Substraten vorhanden sind, wobei sich die Dimensionen der Schlitze zwischen den Begrenzungen der Prozesskammer und den Substraten periodisch ändern.

## Claims

1. Device for continuous chemical vapour deposition under atmospheric pressure on substrates, comprising a reaction chamber open on two oppositely situated sides, along the open sides of which the substrates can be transported whilst sealing the reaction chamber, the reaction chamber having respectively a front- and rear-side wall relative to the transport direction of the substrates, which are connected via two oppositely situated side walls,
***characterised in that***
the side walls have respectively at least two inlets and outlets for process gases which are disposed alternatingly at least in regions in the transport direction.

2. Device according to claim 1,
**characterised in that** the gas inlets and gas outlets are disposed in the form of nozzles on the side walls.

3. Device according to one of the preceding claims,
**characterised in that** a gas inlet on a side wall is assigned to a gas outlet on the oppositely situated side wall with formation of a gas flow which extends essentially perpendicular to the transport direction.

4. Device according to one of the preceding claims,
**characterised in that** the device has at least one gas inlet for the introduction of a precursor for deposition on the substrates.

5. Device according to one of the preceding claims,
**characterised in that** the device has at least one gas inlet for the introduction of etching gas in order to eliminate parasitic depositions.

6. Device according to claim 1,
**characterised in that** the gas inlets and gas outlets are configured in the form of pipes which extend perpendicular to the transport direction and have a plurality of nozzles which spread out over the length of the pipe.

7. Device according to claim 6,
**characterised in that** a plurality of pipes is disposed in the form of blocks.

8. Device according to claim 7,
**characterised in that** one block consists of two gas inlet pipes with a gas outlet pipe situated therebetween.

9. Device according to one of the claims 7 or 8,
**characterised in that** the device has a large number of blocks which are disposed sequentially in the transport direction.

10. Device according to one of the claims 7 to 9,
**characterised in that** the block has an additional gas inlet pipe for an etching gas.

11. Device according to one of the preceding claims,
**characterised in that** the substrates consist of silicon, ceramic, glass and/or composites thereof or layer systems.

12. Chemical vapour deposition reactor containing a heating furnace in which at least two devices which are disposed parallel to each other are disposed according to one of the preceding claims.

13. Chemical vapour deposition reactor containing a heating furnace in which at least two sequentially disposed devices are disposed according to one of the claims 1 to 11.

14. Method for continuous chemical vapour deposition under atmospheric pressure on substrates using a device according to one of the claims 1 to 11, in which the gas supply is controlled such that, during the deposition on the substrates, parasitic depositions in the device are prevented and/or removed at the same time.

15. Method according to claim 14,
**characterised in that** at least one precursor is supplied via at least one gas inlet.

16. Method according to claim 14 or 15,
**characterised in that** gas is suctioned out of the device via at least one gas outlet.

17. Method according to claim 16,
**characterised in that** the suctioning-off is effected via a pump.

18. Method according to one of the claims 14 to 17,
**characterised in that,** by means of periodic change of the composition of the at least one supplied gas, parasitic depositions in the device are prevented and/or removed.

19. Method according to one of the claims 14 to 18,
**characterised in that** parasitic depositions in the device are removed by supplying at least one etching gas.

20. Method according to one of the claims 14 to 19,
**characterised in that** at least one etching gas for removing parasitic depositions is supplied via at least one gas inlet.

21. Method according to claim 20,
**characterised in that** the at least one etching gas is supplied separately via at least one gas inlet.

22. Method according to one of the claims 19 to 21,
**characterised in that** the at least one precursor and the at least one etching gas are supplied via the same gas inlets.

23. Method according to one of the claims 19 to 22,
**characterised in that** the at least one precursor and the at least one etching gas are supplied to the device periodically alternating via different gas inlets.

24. Method according to one of the claims 19 to 23,
**characterised in that** the at least one precursor and the at least one etching gas are chemically compatible with each other.

25. Method according to one of the claims 14 to 24,
**characterised in that** a first gas flow from a gas inlet in the first side wall is guided towards a gas outlet in the second side wall and in parallel thereto a second gas flow from a gas inlet in the second side wall is guided towards a gas outlet in the first side wall in the counter-flow principle.

26. Method according to one of the claims 14 to 25,
**characterised in that** the nozzles of the gas inlet pipes for the at least one precursor are directed towards the substrates so that a gas flow is produced in the direction of the substrates.

27. Method according to one of the claims 14 to 26,
**characterised in that** the nozzles of the gas inlet pipes for the at least one etching gas are directed towards the surfaces of the device with parasitic depositions so that the parasitic depositions are etched back.

28. Method according to one of the claims 14 to 27,
**characterised in that** different process gases are supplied in each block so that different layers or layer compositions are deposited.

29. Method according to one of the claims 14 to 28,
**characterised in that** slots are present between the delimitations of the process chamber and the substrates, the dimensions of the slots between the delimitations of the process chamber and the substrates not changing substantially temporally.

30. Method according to one of the claims 14 to 28,
**characterised in that** slots are present between the delimitations of the process chamber and the substrates, the dimensions of the slots between the delimitations of the process chamber and the substrates changing periodically.

## Revendications

1. Dispositif pour la séparation continue de phase gazeuse sous pression atmosphérique sur des substrats, contenant une chambre de réaction ouverte sur deux côtés opposés l'un à l'autre, le long des côtés ouverts de laquelle les substrats sont transportables, la chambre de réaction étant fermée, ladite chambre de réaction comportant respectivement une paroi frontale et une paroi arrière par rapport à la direction de transport des substrats, lesquelles sont reliées par deux parois latérales opposées l'une à l'autre, **caractérisé en ce que** les parois latérales comportent chacune au moins deux entrées et sorties pour des gaz de processus, lesquelles sont au moins partiellement disposées en alternance dans la direction de transport.

2. Dispositif selon la revendication 1, **caractérisé en ce que** les entrée de gaz et les sorties de gaz sont disposées sous forme de buses sur les parois latérales.

3. Dispositif selon l'une des revendications précédentes, **caractérisé en ce qu'**une entrée de gaz sur une paroi latérale correspond à une sortie de gaz sur la paroi latérale opposée en formant un flux gazeux qui s'étend sensiblement perpendiculairement à la direction de transport.

4. Dispositif selon l'une des revendications précédentes, **caractérisé en ce que** le dispositif comporte au moins une entrée de gaz pour l'application d'un précurseur pour la séparation sur les substrats.

5. Dispositif selon l'une des revendications précédentes, **caractérisé en ce que** le dispositif comporte au moins une entrée de gaz pour l'application de gaz caustique pour éliminer des séparations parasites.

6. Dispositif selon la revendication 1, **caractérisé en ce que** les entrées de gaz et les sorties de gaz se présentent sous la forme de conduits s'étendant perpendiculairement à la direction de transport, avec plusieurs buses réparties sur la longueur de conduit.

7. Dispositif selon la revendication 6, **caractérisé en ce que** plusieurs conduits sont agencés sous forme de blocs.

8. Dispositif selon la revendication 7, **caractérisé en ce qu'**un bloc se compose de deux conduits d'entrée de gaz avec un conduit de sortie de gaz intercalé.

9. Dispositif selon l'une des revendications 7 ou 8, **caractérisé en ce que** le dispositif comporte une pluralité de blocs séquentiellement disposées en direction de transport.

10. Dispositif selon l'une des revendications 7 à 9, **caractérisé en ce que** le bloc comporte un conduit d'entrée de gaz additionnel pour un gaz caustique.

11. Dispositif selon l'une des revendications précédentes, **caractérisé en ce que** les substrats se composent de silicium, céramique, verre et/ou leurs composés, ou de systèmes stratifiés.

12. Réacteur de séparation de phase gazeuse contenant un fourneau où sont disposés parallèlement l'un à l'autre au moins deux dispositifs selon l'une des revendications précédentes.

13. Réacteur de séparation de phase gazeuse contenant un fourneau où sont disposés séquentiellement au moins deux dispositifs selon l'une des revendications 1 à 11.

14. Procédé pour la séparation continue de phase gazeuse sous pression atmosphérique sur des substrats, utilisant un dispositif selon l'une des revendications 1 à 11, où l'amenée de gaz est commandée de manière à empêcher et/ou à éliminer simultanément des séparations parasites dans le dispositif pendant la séparation sur les substrats.

15. Procédé selon la revendication 14, **caractérisé en ce qu'**au moins un précurseur est amené par au moins une entrée de gaz.

16. Procédé selon la revendication 14 ou la revendication 15, **caractérisé en ce que** du gaz est aspiré du dispositif par au moins une sortie de gaz.

17. Procédé selon la revendication 16, **caractérisé en ce que** l'aspiration est réalisée au moyen d'une pompe.

18. Procédé selon l'une des revendications 14 à 17, **caractérisé en ce que** les séparations parasites sont empêchées et/ou éliminées dans le dispositif par modification périodique de la composition du ou des gaz amenés.

19. Procédé selon l'une des revendications 14 à 18, **caractérisé en ce que** les séparations parasites sont éliminées dans le dispositif par l'amenée d'au moins un gaz caustique.

20. Procédé selon l'une des revendications 14 à 19, **caractérisé en ce qu'**au moins un gaz caustique est amené par au moins une entrée de gaz pour éliminer les séparations parasites.

21. Procédé selon la revendication 20, **caractérisé en ce que** le ou les gaz caustique(s) sont amenés séparément par au moins une entrée de gaz.

22. Procédé selon l'une des revendications 19 à 21, **caractérisé en ce que** le ou les précurseur(s) et le ou les gaz caustique(s) sont amenés par les mêmes entrées de gaz.

23. Procédé selon l'une des revendications 19 à 22, **caractérisé en ce que** le ou les précurseur(s) et le ou les gaz caustique(s) sont amenés en alternance périodique par différentes entrées de gaz du dispositif.

24. Procédé selon l'une des revendications 19 à 23, **caractérisé en ce que** le ou les précurseur(s) et le ou les gaz caustique(s) sont chimiquement compatibles entre eux.

25. Procédé selon l'une des revendications 14 à 24, **caractérisé en ce qu'**un premier flux gazeux est amené d'une entrée de gaz dans la première paroi latérale vers une sortie de gaz dans la deuxième paroi latérale et **en ce que**, parallèlement à celui-ci, un deuxième flux gazeux est amené d'une entrée de gaz dans la deuxième paroi latérale vers une sortie de gaz dans la première paroi latérale suivant le principe du contre-courant.

26. Procédé selon l'une des revendications 14 à 25, **caractérisé en ce que** les buses des conduits d'entrée de gaz pour le ou les précurseur(s) sont dirigées vers les substrats, de manière à générer un courant gazeux en direction des substrats.

27. Procédé selon l'une des revendications 14 à 26, **caractérisé en ce que** les buses des conduits d'entrée de gaz pour le ou les gaz caustique(s) sont dirigées vers les surfaces du dispositif avec des séparations parasites, de manière à attaquer les séparations parasites.

28. Procédé selon l'une des revendications 14 à 27, **caractérisé en ce que** différents gaz de processus sont amenés dans chaque bloc, de manière à séparer différentes couches ou combinaisons de couches.

29. Procédé selon l'une des revendications 14 à 28, **caractérisé en ce que** des fentes sont ménagées entre les limites de la chambre de processus et les substrats, les dimensions des dites fentes entre les limites de la chambre de processus et les substrats ne variant pas sensiblement dans le temps.

30. Procédé selon l'une des revendications 14 à 28, **caractérisé en ce que** des fentes sont ménagées entre les limites de la chambre de processus et les substrats, les dimensions des dites fentes entre les limites de la chambre de processus et les substrats variant périodiquement.
